# EUROPÄISCHE PATENTSCHRIFT

(11) **EP 0 939 973 B1**
(45) Veröffentlichungstag und Bekanntmachung des Hinweises auf die Patenterteilung: **20.07.2005**
(21) Anmeldenummer: 97949945.6
(22) Anmeldetag: 18.11.1997
(51) Int. Cl.: H01L 21/314, G01L 9/00

(54) **VERFAHREN ZUR HERSTELLUNG MIKROMECHANISCHER FUNKTIONSELEMENTE**
PROCESS FOR MANUFACTURING MICROMECHANICAL FUNCTIONAL ELEMENTS
PROCEDE DE FABRICATION D'ELEMENTS FONCTIONNELS MICROMECANIQUES

(30) Priorität: 22.11.1996 DE 19648423
(43) Veröffentlichungstag der Anmeldung: 08.09.1999
(73) Patentinhaber: Infineon Technologies AG, 81669 München (DE)
(72) Erfinder: SCHEITER, Thomas, D-82041 Oberhaching (DE); HIEROLD, Christopher, D-81739 München (DE); NÄHER, Ulrich, D-80803 München (DE)
(74) Vertreter: Kottmann, Heinz Dieter, Dipl.-Ing.
(86) Internationale Anmeldenummer: PCT/DE1997/002700
(87) Internationale Veröffentlichungsnummer: WO 1998/024119

(56) Entgegenhaltungen:
- US-A- 4 571 661
- US-A- 5 285 131
- US-A- 5 343 064
- US-A- 5 369 544

## Beschreibung

Die vorliegende Erfindung betrifft ein Verfahren zur Kontrolle von intrinsischem Stress in mikromechanischen Funktionsschichten, die bei mikromechanischen Bauelementen verwendet werden.

Mikromechanische Funktionsschichten, aus denen durch Strukturierung Funktionselemente für mikromechanische Bauelemente, z. B. Membran- oder Brückenstrukturen hergestellt werden, müssen frei von Druckstress, d. h. intrinsischen Druckspannungen, sein. Ein Druckstress in der Schicht führt dazu, dass sich in dem Funktionselement Knicke bilden, d. h. die betreffende Struktur nicht eben bleibt. Eine Ursache für den Aufbau intrinsischer Druckspannungen in Polysiliziumstrukturen, d. h. in polykristallinen Siliziumfilmen, ist in der Eindiffusion von Dotierstoffen bei Hochtemperaturschritten aus an das Polysilizium angrenzendem hochdotiertem Material zu sehen.

Aus der US 5369544 ist ein Drucksensor bekannt, bei dem eine Siliziummembran auf ihrer Unterseite mit einer Siliziumnitridschicht versehen ist. Weiterhin beschreibt die US 4571661 einen Schwingungsfühler, bei dem ein bewegliches Hebelglied aus polykristallinem Silizium besteht, das auf seiner Oberseite und seiner Unterseite mit Siliziumnitrid belegt ist.

Aufgabe der vorliegenden Erfindung ist es, ein Verfahren zur Herstellung mikromechanischer Funktionselemente aus Polysilizium anzugeben, bei dem die Ausbildung von Druckspannungen in dieser Schicht vermieden wird.

Diese Aufgabe wird mit dem Verfahren mit den Merkmalen des Anspruches 1 gelöst. Weitere Ausgestaltungen ergeben sich aus den abhängigen Ansprüchen.

Bei dem erfindungsgemäßen Verfahren wird das Eindiffundieren von Dotierstoffen in die für das Funktionselement vorgesehene Polysiliziumschicht dadurch vermieden, dass auf die Oberfläche der Polysiliziumschicht eine dünne Schutzschicht mittels LPCVD (Low Pressure Chemical Vapor Deposition) aufgebracht wird. Das Material dieser Schutzschicht und dessen Dicke werden so gewählt, daß darin die Diffusionslänge für die zu blockierenden Dotierstoffe bei den angewandten Prozeßtemperaturen kleiner ist als die Dicke der Schutzschicht. So wird verhindert, daß die Dotierstoffe ganz durch die Blockierschicht wandern und in die Polysiliziumschicht gelangen. Die Diffusionslänge der Dotierstoffe hängt von der vorhandenen Temperatur ab. Die Diffusionslänge ist L = (D · t)^{-1/2}. Die Diffusionskonstante (Diffusionskoeffizient) D hängt von der Temperatur ab. Die Diffusionslänge ist bei höherer Temperatur größer. Bei höherer thermischer Belastung des herzustellenden Bauelementes ist daher die Schutzschicht oder Blockierschicht entsprechend dicker aufzubringen.

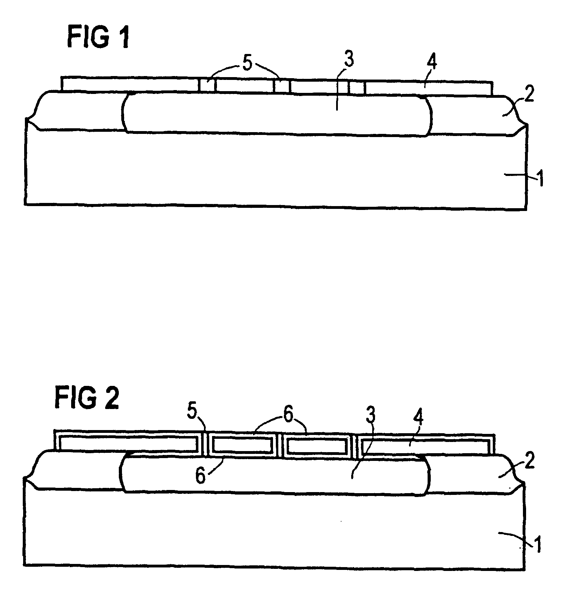

Es folgt eine Beschreibung des Verfahrens anhand der Figuren 1 und 2, die eine über einem Substrat aufgebrachte Membran vor und nach dem Aufbringen der Schutzschicht zeigen.

Figur 1 zeigt als Beispiel auf einem Substrat 1 eine Hilfsschicht 2, in der ein Hohlraum 3 unter einer Membranschicht 4 aus Polysilizium vorhanden ist. Zum Ausätzen des Hohlraumes 3 sind in der Membranschicht 4 Ätzöffnungen 5 hergestellt. Die Membranschicht 4 besteht aus Polysilizium, das üblicherweise für eine kapazitive Messung elektrisch leitend dotiert wird. Auf diese Membranschicht wird dann bei üblichen Prozeßschritten eine Verschlußschicht oder Passivierung aufgebracht, die vorzugsweise BPSG (Borphosphorsilikatglas) ist. Dieses Material ist so hoch dotiert, daß bei anschließenden Prozeßschritten, die bei erhöhter Temperatur erfolgen, Bor und Phosphor aus dem BPSG in das Polysilizium der Membranschicht 4 eindiffundieren. Das bewirkt einen erhöhten Druckstreß in der Membran. Das Eindiffundieren von Dotierstoff in das Polysilizium erfolgt auch von der Unterseite der Membran von der Seite des Hohlraumes 3. Es kann nämlich nicht verhindert werden, daß beim Aufbringen des BPSG von diesem Material auch ein Teil durch die Ätzöffnungen 5 auf die Unterseite der Membran 4, d. h. die dem Hohlraum 3 zugewandte Oberfläche gelangt. Entsprechende Schwierigkeiten ergeben sich bei Verwendung anderer dotierter Materialien, insbesondere dotierter Halbleitermaterialien, die auf das Polysilizium abgeschieden werden.

Dem erfindungsgemäßen Verfahren liegt die Erkenntnis zugrunde, daß eine Schicht, die mittels LPCVD von oben auf das strukturierte Funktionselement aus Polysilizium abgeschieden wird, sich auch an dessen freigeätzter Unterseite anlagert und dort ebenfalls eine ausreichende Schutzschicht bildet. Es ist also durch Verwendung von LPCVD möglich, auch die Unterseite einer freigeätzten Polysiliziumstruktur, die einem Substrat zugewandt ist, mit einer vollständigen Ummantelung durch eine dünne Schutzschicht zu versehen. Als Material für die Schutzschicht kommt z. B. Nitrid, bei einem auf Silizium hergestellten mikromechanischen Bauelement insbesondere Siliziumnitrid (Si₃N₄) in Frage. Es ist auch möglich, Siliziumoxid mittels LPCVD als Schutzschicht abzuscheiden. Die Schutzschicht 6 wird wie in Figur 2 gezeigt auf allen freien Oberflächen der Membran 4 abgeschieden. Es ergibt sich so auch von der Unterseite ein Schutz gegen Eindiffusion von an der Membranoberseite angelagertem dotiertem Material. Die Nitridschicht wird z. B. in einer Dicke von 5 nm bis 50 nm abgeschieden. Vorzugsweise wird die Schicht möglichst dünn abgeschieden, aber mindestens so dick, daß die angestrebte Blockierwirkung in ausreichendem Maße vorhanden ist. Bevorzugte Schichtdicken liegen daher im Bereich von etwa 10 nm bis 20 nm. Mit einer Nitridschicht von etwa 20 nm Dicke kann eine Eindiffusion von Dotierstoffen wie Arsen, Phosphor und Bor in ausreichendem Maß unterbunden werden. Wird die Polysiliziumschicht als Abdeckung eines freistehenden mikromechanischen Elementes, z. B. einer beweglichen Masse eines verkapselten Beschleunigungssensors, verwendet, so wird auch dieses bewegliche Element von der abgeschiedenen Schutzschicht ummantelt. Es ist daher gewährleistet, daß bei Verwendung des erfindungsgemäßen Verfahrens die abgeschiedene Schutzschicht alle freiliegenden Polysiliziumteile des mikromechanischen Bauelementes sowohl auf der Unterseite als auch auf der Oberseite bedeckt und damit einen vollständigen Schutz vor Eindiffusion aus danach abgeschiedenen Schichten aus dotiertem Material bietet.

## Patentansprüche

1. Verfahren zur Herstellung eines mikromechanischen Bauelementes, bei dem zuerst ein Funktionselement (4) mit einer schichtartigen Struktur hergestellt und beidseitig zumindest teilweise freigeätzt wird,
bei dem auf dem Funktionselement (4) mittels LPCVD (low pressure chemical vapor deposition) eine Schicht aus Oxid oder Nitrid als Schutzschicht (6) abgeschieden wird, bei dem nach dem Abscheiden der Schutzschicht (6) dotiertes Material aufgebracht wird und bei dem das Eindiffundieren von Dotierstoff aus dem dotierten Material in das Funktionselement (4) blockiert wird,
**dadurch gekennzeichnet, dass**
das Funktionselement (4) aus Polysilizium besteht,
die Dicke der Schutzschicht (6) mit 5 nm bis 50 nm ausreichend groß gewählt wird, um das Eindiffundieren von Dotierstoff aus dem dotierten Material in das Funktionselement (4) nachhaltig zu blockieren, und
die Abscheidung der Schutzschicht (6) so erfolgt, dass alle freigelegten Anteile der Oberfläche des Funktionselementes (4) damit bedeckt werden.

2. Verfahren nach Anspruch 1,
**dadurch gekennzeichnet, dass**
die Schutzschicht (6) aus Siliziumnitrid in einer Dicke von 10 nm bis 20 nm abgeschieden wird.

3. Verfahren nach Anspruch 1 oder 2,
**dadurch gekennzeichnet, dass**
als dotiertes Material Borphosphorsilikatglas (BPSG) abgeschieden wird.

4. Verfahren nach einem der Ansprüche 1 bis 3,
**dadurch gekennzeichnet, dass**
- das Funktionselement (4) als Membran eines Drucksensors vorgesehen wird,
- die Membran auf einer Hilfsschicht (2) aufgebracht wird,
- diese Hilfsschicht durch in der Membran hergestellte Ätzlöcher (5) unter der Membran entfernt wird, sodass ein Hohlraum (3) entsteht, und
- die Schutzschicht (6) abgeschieden wird, bevor der Hohlraum (3) nach außen verschlossen wird, sodass eine Abscheidung der Schutzschicht (6) auch durch die Ätzlöcher (5) in der Membran hindurch auf die dem Hohlraum (3) zugewandte Seite der Membran erfolgt.

## Claims

1. Method for producing a micromechanical component,
in which firstly a functional element (4) with a layer-like structure is produced and at least partially etched free on both sides,
in which a layer made of oxide or nitride is deposited as a protective layer (6) on the functional element (4) by means of LPCVD (low pressure chemical vapour deposition),
in which doped material is applied after the deposition of the protective layer (6), and in which the indiffusion of dopant from the doped material into functional element (4) is blocked,
**characterized in that**
the functional element (4) comprises polysilicon,
the thickness of the protective layer (6), with a value of 5 nm to 50 nm, is chosen to be large enough to block the indiffusion of dopant from the doped material into the functional element (4) in a sustained manner,
and the protective layer (6) is deposited in such a way that all uncovered portions of the surface of the functional element (4) are covered thereby.

2. Method according to Claim 1,
**characterized in that**
the protective layer (6) is deposited in a manner made of silicon nitride with a thickness of 10 nm to 20 nm.

3. Method according to Claim 1 or 2,
**characterized in that**
borophosphosilicate glass (BPSG) is deposited as the doped material.

4. Method according to one of Claims 1 to 3,
**characterized in that**
- the functional element (4) is provided as the diaphragm of a pressure sensor,
- the diaphragm is applied on an auxiliary layer (2),
- said auxiliary layer is removed below the diaphragm through etching holes (5) produced in the diaphragm, so that a cavity (3) arises, and
- the protective layer (6) is deposited before the cavity (3) is closed off towards the outside, so that the protective layer (6) is also deposited through the etching holes (5) in the diaphragm onto that side of the diaphragm which faces the cavity (3).

## Revendications

1. Procédé de fabrication d'un élément micromécanique, dans lequel on fabrique d'abord un élément (4) fonctionnel ayant une structure de type à couche et on le met à nu par attaque des deux côtés au moins en partie,
dans lequel on dépose comme couche (6) de protection sur l'élément (4) fonctionnel au moyen d'un LPCVD (low pressure chemical vapor deposition), une couche d'oxyde ou de nitrure dans lequel après le dépôt de la couche (6) de protection, on dépose de la matière dopée et dans lequel on bloque la diffusion de substance de dopage hors de la matière dopée dans l'élément (4) fonbtionnel,
**caractérisé en ce que**
l'élément (4) fonctionnel est en polysilicium,
l'épaisseur de la couche (6) de protection de 5 nm à 50 nm est choisie suffisamment grande pour bloquer de manière persistante la diffusion de la substance de dopage hors de la matière dopée dans l'élément (4) fonctionnel, et
le dépôt de la couche (6) de protection s'effectue de façon à ce que toutes les parties mises à nu de la surface de l'élément (4) fonctionnel soient ainsi revêtues.

2. Procédé suivant la revendication 1,
**caractérisé en ce que**
la couche (6) de protection en nitrure de silicium est déposée en une épaisseur de 10 nm à 20 nm.

3. Procédé suivant la revendication 1 ou 2,
**caractérisé en ce que**
du verre au borophosphosilicate (VBPS) est déposé en tant que matière dopée.

4. Procédé suivant l'une des revendications 1 à 3,
**caractérisé en ce que**
- l'élément (4) fonctionnel est prévu sous la forme d'une membrane d'un capteur de pression,
- la membrane est déposée sur une couche (2) auxiliaire,
- cette couche auxiliaire est éliminée sous la membrane par des trous (5) d'attaque pratiqués dans la membrane de manière à créer une cavité (3), et
- la couche (6) de protection est déposée avant que la cavité (3) soit fermée vers l'extérieur de manière à effectuer également un dépôt de la couche (6) de protection par les trous (5) d'attaque à travers la membrane, du côté, tourné vers la cavité (3), de la membrane.
